Europäisches Patentamt

European Patent Office

Office européen des brevets

(11) Numéro de publication: **0 017 535**
A1

## (12) DEMANDE DE BREVET EUROPEEN

(21) Numéro de dépôt: **80400355.6**

(22) Date de dépôt: **18.03.80**

(51) Int. Cl.³: **G 01 R 13/40**
**G 01 D 13/22**

(30) Priorité: **28.03.79 FR 7907751**

(43) Date de publication de la demande:
**15.10.80 Bulletin 80/21**

(84) Etats Contractants Désignés:
**DE GB IT NL**

(71) Demandeur: **SOCIETE SEREG**
**12, place des Etats-Unis**
**F-92120 Montrouge(FR)**

(72) Inventeur: **Boye, Jean**
**4, Allée de la Fôret**
**F-91370 Verrieres Le Buisson(FR)**

(74) Mandataire: **Colombe, Michel**
**GIERS SCHLUMBERGER B.P. 121**
**F-92124 Montrouge Cedex(FR)**

(54) Dispositif d'affichage par trait lumineux.

(57) Dispositif d'affichage comportant deux groupes de sources lumineuses (28,45) juxtaposées permettant d'une part, l'affichage de la valeur de mesure d'une grandeur physique qui est décomposée en signaux représentatifs des différentes unités d'ordre. Et d'autre part l'affichage de deux valeurs différentes affichées par les deux groupes (par exemple: un signal de mesure et un signal de consigne).

./...

EP 0 017 535 A1

Croydon Printing Company Ltd.

Fig. 1

## Dispositif d'affichage par trait lumineux.

La présente invention concerne les dispositifs d'affichage et plus particulièrement les dispositifs permettant d'afficher des grandeurs analogiques sous la forme d'une image lumineuse comme par exemple sous l'aspect d'un trait lumineux dont la longueur est une fonction de la valeur de la grandeur analogique.

Dans beaucoup de domaines des grandeurs physiques, après avoir été captées sont affichées afin que des observateurs puissent en percevoir les valeurs. Un moyen commode pour ces observateurs de percevoir les valeurs affichées est d'utiliser leurs yeux comme récepteurs.

Une des façons connues d'afficher la valeur d'une grandeur physique est d'utiliser un transducteur apte à recevoir la grandeur physique et à la transformer en un déplacement correspondant, par exemple d'un index par rapport à une échelle graduée. La position de l'index comparée à des graduations d'échelle permet d'indiquer la valeur numérique de la grandeur physique.

Les index les plus courants sont par exemple les aiguilles. Mais il existe aussi d'autres index, comme des spots lumineux, des échelles défilantes, des zones de couleurs sur des tambours, etc. Tous ces index sont soumis à des déplacements qui sont fournis par des pièces mécaniques en mouvement. Ces dispositifs dynamiques ont des avantages et des inconvénients.

Actuellement, la tendance se porte malgré tout vers des dispositifs statiques à affichage lumineux pour leurs avantages qui sont par exemple la durée de vie, la fiabilité et la bonne tenue aux contraintes. Ces dispositifs statiques sont généralement constitués par un trait lumineux dont la longeur est représentative de la valeur de la grandeur à afficher. Ce trait peut être obtenu par une pluralité de sources lumineuses qui sont disposées les unes à côté des autres, le long d'une courbe qui, pour des représentations analogiques de grandeurs est généralement constituée par un segment de droite.

Les sources lumineuses qui sont utilisées sont de différents types, par exemple des dispositifs à filaments, fluorescence, à cristaux liquides (L C D), à plasma ou à diodes électroluminescentes.

Pour obtenir une représentation de la valeur de la grandeur physique considérée à afficher, il suffit de commander un nombre déterminé de sources lumineuses juxtaposées de façon à former un trait lumineux sensiblement continu du moins pour l'oeil de l'observateur, fonction de la grandeur physique à afficher.

Bien évidemment la précision d'un tel affichage lumineux est notamment fonction du nombre de sources lumineuses par unité de pas de l'échelle de lecture qui se trouve en regard du trait lumineux possible. Partant de telles considérations, pour obtenir une bonne précision, il faudrait alors augmenter d'une part la longueur intrinsèque des unités de pas de l'échelle et d'autre part, le nombre de sources lumineuses par ces mêmes unités de pas.

Mais en fait, ces afficheurs lumineux sont généralement utilisés dans des appareils de mesure standardisés et la longueur des échelles ne peut être augmentée dans de grandes proportions.

De même, l'augmentation du nombre des sources lumineuses est limitée par leur taille et leur encombrement, car la taille de ces sources lumineuses ne peut aller au-delà d'une certaine dimension, car alors, l'oeil de l'observateur serait incapable de percevoir l'information émise et le gain en précision obtenu technologiquement serait perdu physiologiquement.

La présente invention a pour but de réaliser un dispositif d'affichage lumineux dans lequel le nombre des sources lumineuses n'est pas considérable et la longueur du trait lumineux qu'elles peuvent réaliser est relativement court, mais dont la précision de la lecture et de l'affichage est considérablement augmentée.

Plus précisément, la présente invention a pour objet un dispositif d'affichage de la valeur d'une grandeur physique par trait lumineux formé par une pluralité de sources lumineuses juxtaposées les unes à côté des autres le long d'une courbe déterminée, des moyens pour commander l'allumage d'un nombre déterminé desdites sources lumineuses, fonction de la valeur de ladite grandeur analogique, caractérisé par le fait qu'il comporte des moyens pour commander un premier groupe desdites sources lumineuses, des moyens pour commander un deuxième groupe desdites sources lumoneuses, des moyens pour décomposer la valeur de ladite grandeur physique en des signaux représentatifs des différentes unités d'ordre, des moyens pour commander l'affichage de la valeur de l'unité d'ordre la plus grande sur le premier groupe desdites sources et des moyens pour commander l'affichage de l'unité d'ordre la plus faible multipliée par un facteur donné de multiplication sur ledit deuxième groupe de sources lumineuses.

D'autres caractéristiques et avantages de la présente invention apparaîtront au cours de la description suivante donnée en regard du dessin annexé à titre illustratif, mais nullement limitatif dans lequel :

- la figure 1 représente un schéma synoptique fonctionnel d'un mode de réalisation d'un dispositif d'affichage selon l'invention,
- la figure 2 représentedes schémas comparatifs des moyens de visualisation du dispositif d'affichage permettant de bien faire ressortir les avantages et intérêts de la présente invention.

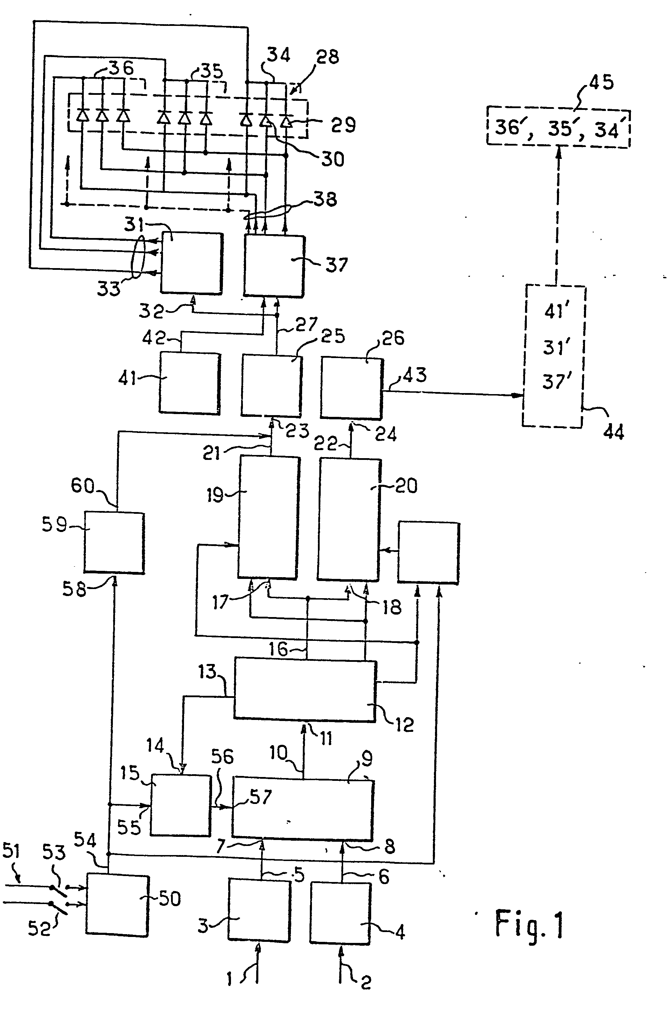

La figure 1 représente un schéma synoptique fonctionnel d'un mode de réalisation d'un dispositif de visualisation selon l'invention. Ce mode de visualisation est un dispositif comportant deux barres de visualisation par diodes lumineuses, chacune des deux barres servant dans un premier temps à visualiser respectivement un signal de mesure qui peut varier en fonction de celle du paramètres qu'il représente et un signal de référence ou de "consigne", ajustable à volonté et représentant une image du paramètre à mesurer sur laquelle devrait être fixé le signal de mesure.

En effet, ce genre de dispositif est couramment, quoique non exclusivement,utilisé dans les systèmes de régulation de procédés industriels. Dans ceux-ci, il est souvent nécessaire de maintenir la valeur d'un paramètre comme par exemple une pression, une température, etc. à une valeur constante. Pour cela, la valeur du paramètre est mesurée et généralement transformée en un signal électrique qui est utilisé par différents moyens d'asservissements connus pour réguler sa valeur à une valeur sensiblement constante. Il est bien compréhensible que des observateurs doivent pouvoir se renseigner très rapidement d'une part sur la valeur du signal de mesure donc du paramètre,

5

et d'autre part sur l'écart qui le sépare avec la valeur qu'il est souhaitable d'obtenir pour le signal de mesure, c'est-à-dire du signal de consigne. Il existe donc des dispositifs de visualisation qui affichent à la fois la valeur du paramètre et à côté la valeur sur laquelle il devrait se maintenir

Ceci est obtenu par des dispositifs qui comportent des barres lumineuses juxtaposées, une affichant la valeur du signal de mesure, l'autre affichant la valeur du signal de consigne. La juxtaposition des deux barres lumineuses permettant à l'observateur de percevoir la position de la valeur du paramètre par rapport à sa valeur souhaitée et donc éventuellement la différence qui peut exister entre elles.

Le dispositif illustré sur la figure 1 permet de réaliser les fonctions mentionnées ci-dessus, c'est-à-dire l'affichage des deux signaux de mesure et de consigne, et aussi, à la demande, l'affichage de façon plus précise des valeurs soit du signal de mesure ou soit de consigne.

Plus précisément, le dispositif comporte, comme ceux qui sont commercialisés par la Société National Semiconductor sous la référence LM 324 deux bornes d'entrées 1 et 2 qui sont reliées respectivement à des circuits adaptateurs 3 et 4 par exemple des circuits linéaires. La sortie respective 5 et 6 de ces deux circuits linéaires 3 et 4 sont reliées à deux entrées 7 et 8 d'un commutateur analogique 9. Sa sortie 10 est reliée à l'entrée 11 d'un convertisseur analogique-numérique comme celui qui est vendu par exemple par la Société Molotorola sous la référence commerciale MC 14 433. Une sortie de pilotage 13 de ce convertisseur 12 est reliée à une première entrée de commande 14 d'un circuit logique 15 comme par exemple une bascule bistable, notamment celle de RCA référencée CD 4013, cette bascule permettant la mise en forme du signal délivré par le convertisseur 12 à sa sortie 13. La sortie 16, du convertisseur 9 est reliée à la fois aux entrées 17 et 18 respectivement de deux compteurs 19 et 20 qui pourront comporter un nombre déterminés de registres qui, dans l'exemple considéré est égal à deux. Chacune des deux sorties 21 et 22 respectivement des deux compteurs 19 et 20 sont reliées aux entrées 23 et 24 respectivement de deux décodeurs 25 et 26. De façon plus pratique, les entrées des décodeurs comme ceux de la Société RCA référencés CD 4028, sont reliés aux sorties couramment référencées " B, C, D " des compteurs, comme ceux commercialisés par la même Société RCA sous la référence commerciale CD 4029.

La sortie 27 du décodeur 25 est reliée par un circuit d'interface à la barre lumineuse 28 constituée d'une pluralité de diodes électroluminescentes 29, 30, etc. juxtaposées les unes à côté des autres sur un segment de droite pour pouvoir réaliser un trait lumineux d'au moins une dizaine de centimètres de longueur. Ce trait est obtenu généralement par un nombre de diodes (0 à 100). Ces moyens de commande comportent des circuits de commande de cathode 31 dont l'entrée 32 est reliée à la sortie 27 et dont les "n" sorties 33 sont reliées respectivement aux cathodes de "n" groupes de diodes, 34, 35, 36, etc. Ce nombre "n" est égal à 10 à cause de l'affichage en analogique décimal. Ces moyens de liaison comportent aussi des circuits de commande d'anode 37 dont les "n" sorties 38 sont reliées comme représenté sur la figure 1 respectivement aux anodes d'une diode de chacune de "n" groupes de diodes 34, 35, 36 ("n" étant toujours égal à 10). Ces circuits de commande de diodes permettent de commander l'alimentation des diodes en courant électrique provenant par exemple d'un générateur de courant 41 dont la sortie 42 peut être reliée aux anodes de diodes à travers le circuit de commande 37. La sortie 43 du décodeur 26 est reliée à un autre ensemble d'éléments électroniques représentés schématiquement en 44 pour alimenter la deuxième barre lumineuse 45 esquissée sur la figure. Cet ensemble électronique 44 comporte les mêmes éléments agencés de la même façon que les éléments 31, 34, 35, 36, 37 et 41 qui sont associés au décodeur 25 et qui seront respectivement référencés 31', 34', 35', 36', 37' et 41'. Ceux-ci n'ont pas été spécifiquement représentés en eux-mêmes dans un but de simplification du dessin.

Comme il a été dit précédemment, le dispositif peut afficher les valeurs des deux signaux de mesure et de consigne, respectivement sur les deux barres lumineuses 28 et 45.

Mais il peut, selon un montage de la présente invention, aussi afficher à la demande, pendant un temps déterminé, par exemple soit le signal de mesure, soit le signal de consigne, avec une plus grande précision que lorsque les deux barres affichent respectivement les deux signaux.

Pour cela, le dispositif comporte en outre un circuit logique 50 recevant à ses entrées de commande 51 les informations demandant le fonctionnement ou affichage plus précis par le moyen 52 par exemple le signal de consibne et par le moyen 53 le signal de mesure. Ces moyens 52 et 53, représentés schématiquement sont en fait des contacts électroniques "fugitifs" qui, par le circuit logique 50 permet de les maintenir pendant une durée constante déterminée par exemple de l'ordre de 5 secondes. La sortie 54 du circuit 50 est reliée à une entrée 55 de commande de la bascule 15 dont la sortie 56 est reliée à une entrée de blocage 57 du commutateur 9. La sortie 54 du circuit logique 50 est aussi reliée à une entrée 58 d'un circuit 59 dont la sortie 60 est reliée à l'entrée 23 du décodeur 25. Ce circuit logique 59 permet de commander à travers le décodeur la conduction des diodes. La sortie 54 du circuit logique 50 est aussi reliée à l'entrée 61 d'un deuxième circuit logique d'adaptation 62 de commande dont la sortie 63 est reliée à une entrée de commande 64 du compteur 20. Il est à préciser qu'une sortie auxiliaire 64 du convertisseur analogique numérique 12 est reliée d'une part à une entrée 65 du compteur 6 et à une deuxième entrée 66 du deuxième circuit logique 62. Les différentes fonctions des éléments ci-dessus et l'ensemble du fonctionnement du dispositif apparaîtront à la description suivante ci-après.

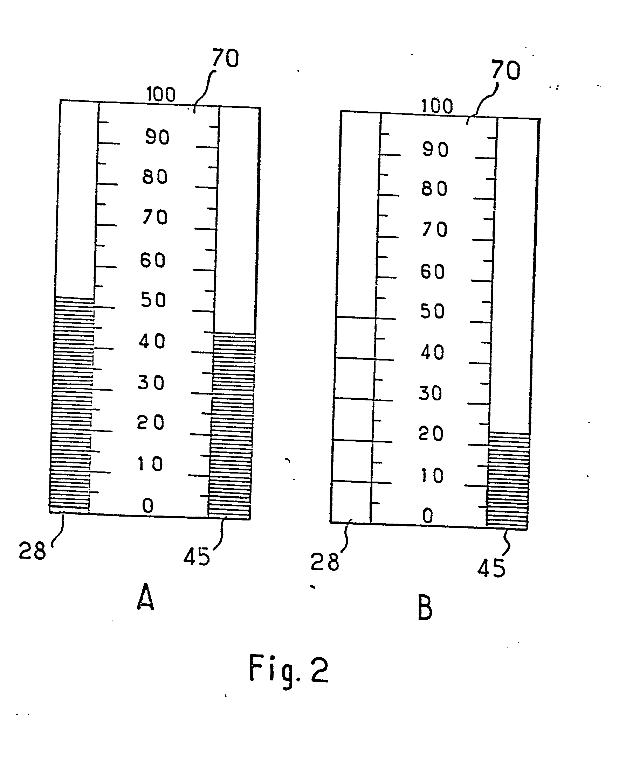

Il est tout d'abord mentionné que le dispositif comporte le commutateur 9 afin de n'utiliser qu'un seul convertisseur analogique-numérique 12. Pour cela la fonction essentielle du commutateur et du convertisseur sera d'alimenter de façon périodique l'une et l'autre des deux barres lumineuses 34 et 45 mais avec une vitesse suffisamment grande pour que les diodes apparaissent toujours allumées à l'oeil humain, en se basant sur le principe de la rémanence rétinienne. De plus, les diodes des barres lumineuses ne seront pas allumées toutes en même temps, mais le seront successivement les unes après les autres à une vitesse relativement grande pour qu'elles apparaissent toujours allumées à l'oeil de l'observateur sur une hauteur qui sera déterminée en fonction de la valeur du signal qui sera affiché. Si l'on prend par exemple le cas de la figure 2A, la barre lumineuse 28 est représentée à gauche par un ensemble de traits représentant les diodes allumées illustrant une valeur de 52 par rapport à l'unité maximale 100. Dans le cas du fonctionnement lorsque le signal sera appliqué à l'entrée de la barre lumineuse 28 la cinquante deuxième diode référencée par rapport à l'échelle sera d'abord allumée et éteinte, ensuite toutes les diodes seront allumées successivement vers la diode référencée 0. Mais la vitesse de commande d'allumage de ces diodes sera aussi suffisamment grande pour que les diodes référencées de 0 à 52 apparaissent allumées toutes en même temps à l'oeil de l'observateur. Il en sera de même d'ailleurs pour la barre 45 qui affichera par exemple le signal de mesure alors que la barre 28, elle, affichera le signal de consigne.

Pour le fonctionnement du dispositif illustré sur la figure 1, on suppose tout d'abord que ce fonctionnement est dans le cas le plus courant, c'est-à-dire celui de l'affichage des deux signaux respectivement sur les deux barres, et que par exemple, il doit afficher sur la barre 28 le signal de consigne et sur la barre 45 le signal de mesure. Les signaux sont appliqués respectivement aux entrées 1 et 2 sous forme analogique puis adaptés pour être appliqués aux deux entrées respectives du commutateur 9. Les signaux obtenus à la sortie du commutateur sont envoyés par le convertisseur analogique numérique qui nécessite, pour cette conversion, en sortie multiplexée, une horloge donnant des impulsions à un rythme déterminé. Cette même horloge sert de même à envoyer des signaux sur la sortie 13 pour commander la bascule 15 de façon qu'elle commande le commutateur 9 pour appliquer alternativement sur l'entrée 11 du convertisseur 12 les signaux reçus aux entrées respectives 1 et 2.

Le signal analogique est appliqué à l'entrée 11 après avoir été ramené à une valeur par exemple de 0 à 2 volts.

Le convertisseur analogique 12 délivre à sa sortie une sortie multiplexée de par exemple un maximum de 3 digits dans le cas illustrant l'invention ; ces digits initialisent les deux registres par exemple du compteur 19 qui reçoit le signal multiplexé représentant le signal de consigne. Dans l'exemple cité où la diode 52 doit être référencée par allumage, les deux registres du compteur 19 seront initialisés de façon que l'on obtienne sur les sorties référencées pour les dizaines et les unités respectivement "5" et "2" un "1" logique. De ce fait, la diode ayant pour référence 52, c'est-à-dire le chiffre 5 des dizaines et le chiffre 2 des unités, sera allumée Ceci s'effectue par commande simultanée des cathodes du cinquième groupe, c'est-à-dire des diodes référencées de 50 à 59 et des anodes correspondant aux deuxièmes diodes de chaque dizaine, c'est-à-dire les anodes des diodes 2, 12, 22, etc. En fait, il n'y aura que l'anode et la cathode de la cinquante deuxième diode qui seront commandées à travers les circuits 31 et 37. A partir de cet instant, par le signal logique émanant du circuit 62 et commandé par les signaux d'horloge en provenance du convertisseur analogique-numérique 12 délivrés à la sortie 64 est commandée la remise à zéro pas à pas du compteur en partant de l'unité 52. Dans ce cas le registre des unités est en premier vidé pour commander l'allumage des diodes 52, 51 jusqu'à la diode 42, à partir de cette diodes le registre des dizaines est vidé une première fois d'une unité.

Ensuite, à partir de la diode 42, le registre des unités sera encore vidé de dix unités pour arriver jusqu'à la diode 32 et celui des dizaines encore d'une unité, et ainsi de suite jusqu'à la diode 2. Enfin, le registre des unités sera vidé des deux dernières unités pour arriver à allumer la diode référencée 0. On voit ainsi que toutes les diodes de la cinquante deuxième à la dernière auront été allumées et ce, suffisamment vite pour que l'oeil puisse croire que toutes les diodes ont été allumées en même temps.

Il en est de même pour le signal de mesure qui, dans le cas illustré affiche la valeur 45, c'est-à-dire que la quarante cinquième diode sera allumée et ainsi de suite, ces commandes étant obtenues par le circuit du compteur 20 avec les deux registres des dizaines et des unités et le circuit logique 26 associé à l'ensemble du circuit référencé 44 pour alimenter la barre lumineuse 45 de la même façon que la barre 28 est alimentée.

Ainsi qu'il a été déjà dit, lorsque la barre lumineuse 45 sera commandée, la barre lumineuse 34 ne sera pas alimentée, mais du fait du phénomène de la rémanence rétinienne, l'observateur pourra voir simultanément sur les deux barres lumineuses deux traits lumineux et pourra donc comparer la valeur respective des signaux de consigne et de mesure. Il pourra vérifier si le signal de consigne a la valeur "52", que le signal de mesure est un peu faible et qu'il est nécessaire d'agir sur la chaîne de régulation pour lui donner la valeur la plus proche de cette valeur de consigne "52".

D'une façon générale, un tel affichage est suffisant, cependant quelquefois, il est nécessaire d'avoir plus de précision sur la valeur soit du signal de mesure, soit du signal de consigne, notamment dans ce dernier cas, au moment de son élaboration pour le réglage d'une chaîne de régulation. Pour connaître avec plus de précision la valeur de ces signaux, le circuit logique 50 comporte des commutateurs qui permettent de commander un affichage avec plus de précision. Par exemple, pour afficher le signal de consigne avec plus de précision, il faut agir sur la commande des moyens 52 pour que, automatiquement dans ce cas, le convertisseur analogique-numérique à 3 digits initialise respectivement les registres des compteurs 19 et 20 en inhibant les deux affichages des signaux de mesure et de régulation.

Dans ce cas alors le registre des dizaines du compteur 19 sera seul initialisé c'est-à-dire pour le chiffre 5 pour

12

l'exemple 52 considéré sur la figure 2A ; par contre, les deux registres du compteur 20 seront respectivement initialisés, celui des dizaines par l'unité c'est-à-dire le chiffre "2" de l'exemple considéré et le deuxième, celui des unités, par le dixième de la valeur du signal de mesure, c'est-à-dire "3".

De ce fait, les deux barres seront respectivement allumées comme montré sur la figure 2B. La barre lumineuse 28 montrera uniquement les diodes des dizaines allumées, c'est-à-dire les diodes référencées 50, 40, 30, 20 et 10, tandis que la barre 45 sera allumée pour obtenir le chiffre 23 de la même façon que précédemment décrit en regard de la figure 2A.

Cependant, pour n'afficher sur la barre 28 que les diodes correspondant aux unités des dizaines entières, le registre des unités du compteur 19 est constamment maintenu à 0 et dans ce cas lorsque le registre des dizaines est ramené successivement à zéro il ne sera uniquement allumé que le nombre des dizaines, c'est-à-dire les diodes se trouvant juste en regard des références 50, 40, 30, 20 et 10 sur l'échelle 60.

Pour la barre 45 l'allumage des 23 dernières diodes se fera comme précédemment décrit, c'est-à-dire que le registre des unités sera vidé une première fois de dix unités et ensuite le registre des dizaines d'une unité et ainsi de suite pour vider complètement les deux registres du compteur 20.

On comprend que ce mode de fonctionnement du dispositif permet d'afficher avec plus de précision le signal de mesure puisqu' il le visualise avec une précision du dizième, alors que dans le cas précédent il n'était affiché qu'avec une précision de l'unité.

13

Il est à noter que pendant cette visualisation, il est ainsi possible d'agir sur la valeur du signal de consigne pour lui donner la valeur désirée avec plus de précision. Il pourra en être de même pour le signal de mesure.

Il est possible de plus, avec un tel dispositif, de réaliser d'autres fonctions comme celle par exemple de l'indication d'un dépassement en limite inférieure et/ou supérieur du ou des deux signaux. Ceci peut être obtenu par la commande de l'allumage d'une diode chaque fois qu'il y a un dépassement, et même au moyen d'un générateur basse fréquence de faire clignoter cette diode.

14

Revendications

1. Dispositif d'affichage de la valeur d'une grandeur physique par trait lumineux par une pluralité de sources lumineuses juxtaposées les unes à côté des autres le long d'une courbe déterminée, comprenant des moyens pour commander l'allumage d'un nombre déterminé desdites sources lumineuses fonction de la valeur de ladite grandeur, caractérisé par le fait qu'il comporte des moyens pour commander un premier groupe desdites sources lumineuses, des moyens pour commander un deuxième groupe desdites sources lumineuses, des moyens pour décomposer la valeur de ladite grandeur en des signaux représentatifs des différentes unités d'ordre, des moyens pour commander l'affichage de l'unité d'ordre la plus grande sur le premier groupe desdites sources, et des moyens pour commander l'affichage de l'unité d'ordre la plus faible, multipliée par un facteur donné, sur ledit deuxième groupe de sources lumineuses.

2. Dispositif selon la revendication 1, caractérisé par le fait que lesdits moyens pour décomposer la valeur de ladite grandeur en des signaux représentatifs des différentes unités d'ordre comportent un circuit d'élaboration d'une valeur numérique fonction de la valeur de ladite grandeur physique, au moins deux registres de comptage, chaque registre mémorisant les valeurs de chaque unité d'ordre de la valeur de ladite grandeur transformée en valeur numérique.

3. Dispositif selon la revendication 2, caractérisé par le fait que lesdits moyens pour commander l'affichage comportent un générateur d'impulsions pour vider lesdits registres à partir de la valeur mémorisée et des moyens pour relier la sortie desdits registres aux différentes sources lumineuses, chaque sortie desdits registres étant associée à une source lumineuse ayant un ordre déterminé représentant une valeur déterminée pour ladite grandeur physique.

4. Dispositif selon la revendication 3, caractérisé par le fait que ledit générateur délivre des impulsions à une fréquence déterminée de façon à ce que toutes les sources lumineuses puissent être allumées et éteintes dans un temps égal au moins à celui de la persistance rétinienne de l'oeil d'un observateur.

5. Dispositif d'affichage de la valeur d'une grandeur analogique par trait lumineux, caractérisé par le fait qu'il comporte des moyens d'entrée, un convertisseur analogique-numérique relié à la sortie desdits moyens d'entrée, des moyens de comptage alimentés par ledit convertisseur, au moins deux barres lumineuses comportant une pluralité de sources lumineuses le long d'une courbe déterminée et des moyens de liaison entre lesdits moyens de comptage et lesdites sources lumineuses.

6. Dispositif selon la revendication 5, caractérisé par le fait que lesdits moyens d'entrée comportent au moins deux linéarisateurs et un commutateur dont les deux entrées sont reliées respectivement aux sorties des deux linéarisateurs, la sortie dudit commutateur étant reliée à l'entrée dudit convertisseur analogique-numérique.

7. Dispositif selon l'une des revendications 5 et 6, caractérisé par le fait que lesdits moyens de comptage comportent au moins deux compteurs ayant au moins deux registres pouvant mémoriser les valeurs respectivement d'au moins deux unités d'ordre de ladite grandeur analogique.

8. Dispositif selon l'une des revendications 5 à 7, caractérisé par le fait que les sources lumineuses sont constituées par des diodes électroluminescentes.

16

9. Dispositif selon la revendication 8, caractérisé par le fait que lesdits moyens de liaison entre les sorties de comptage et lesdites diodes comportent des moyens pour commander les cathodes par groupe de "n" diodes et des moyens pour commander l'alimentation des anodes de chacune des diodes portant la même référence d'ordre de chaque groupe des "n" diodes.

Fig.1

Fig. 2

**Office européen des brevets**

## RAPPORT DE RECHERCHE EUROPEENNE

Numéro de la demande

EP 80 40 0355

| DOCUMENTS CONSIDERES COMME PERTINENTS | | | CLASSEMENT DE LA DEMANDE (Int. Cl.³) |
|---|---|---|---|
| Catégorie | Citation du document avec indication, en cas de besoin, des parties pertinentes | Revendication concernée | |
| X | <u>FR - A - 2 167 854</u> (LOTTERING) <br> * Figures; page 2, ligne 25 à page 3, ligne 39; page 5, ligne 19 à la fin de la page * <br><br> -- | 1-3, 5,7-9 | G 01 R 13/40 <br> G 01 D 13/22 |
| X | <u>DE - A - 2 739 902</u> (SIEMENS) <br> * Figure 1; page 6, lignes 15-28 * | 1-3,5, 8 | |
| | -- <br><br> PROCEEDINGS OF THE SOCIETY FOR INFORMATION DISPLAY, vol. 15, no. 1, premier trimestre 1974, Los Angeles, US <br> R.L. SKOVHOLT "Solid state vertical scale instruments", pages 33-40. <br><br> * Page 36, colonne 1, ligne 10 à page 39, ligne 4 * <br><br> ---- | 4-9 | **DOMAINES TECHNIQUES RECHERCHES (Int. Cl.³** <br><br> G 01 D 7/02 <br> 7/04 <br> 13/22 <br> G 01 R 13/00 <br> 13/02 <br> 13/14 <br> G 06 F 3/14 |

**CATEGORIE DES DOCUMENTS CITES**

X: particulièrement pertinent
A: arrière-plan technologique
O: divulgation non-écrite
P: document intercalaire
T: théorie ou principe à la base de l'invention
E: demande faisant interférence
D: document cité dans la demande
L: document cité pour d'autres raisons

&: membre de la même famille. document correspondant

Le présent rapport de recherche a été établi pour toutes les revendications

| Lieu de la recherche | Date d'achèvement de la recherche | Examinateur |
|---|---|---|
| La Haye | 02-06-1980 | LLOYD |

OEB Form 1503.1 06.78